# EUROPEAN PATENT SPECIFICATION

(11) **EP 2 894 681 B1**
(45) Date of publication and mention of the grant of the patent: **18.04.2018**
(21) Application number: 13834764.6
(22) Date of filing: 26.08.2013
(51) Int. Cl.: H01L 35/14, C01B 33/06, B22F 3/14, B22F 3/16, C22C 1/02, C22C 29/18, B22F 3/105

(54) **METAL MATERIAL HAVING n-TYPE THERMOELECTRIC CONVERSION PERFORMANCE**
METALLMATERIAL MIT THERMOELEKTRISCHER N-TYP-UMWANDLUNGSLEISTUNG
MATÉRIAU MÉTALLIQUE À PERFORMANCE DE CONVERSION THERMOÉLECTRIQUE DE TYPE n

(30) Priority: 04.09.2012 JP 2012194488
(43) Date of publication of application: 15.07.2015
(73) Proprietor: National Institute of Advanced Industrial Science and Technology, Tokyo 100-8921 (JP)
(72) Inventor: FUNAHASHI, Ryoji, Ikeda-shi Osaka 563-8577 (JP)
(74) Representative: Held, Stephan
(86) International application number: PCT/JP2013/072680
(87) International publication number: WO 2014/038418

(56) References cited:
- JP-A- 2012 124 243
- JP-A- 2012 124 243
- JP-A- 2012 174 849
- KUZ'MA YU B ET AL: "Untersuchungen im Dreistoff Mn-Al-Si", MONATSHEFTE FUER CHEMIE: AN INTERNATIONAL JOURNAL OF CHEMISTRY, SPRINGER WIEN, AT, vol. 94, 1 January 1964 (1964-01-01), pages 1266-1271, XP008179829, ISSN: 0026-9247, DOI: 10.1007/BF00904724
- TAKAHIRO YAMADA ET AL: "Synthesis of Mn(AlxSi1-x)2+[delta] Solid Solutions Using NaAlSi and Their Thermoelectric Properties", FUNTAI OYOBI FUNMATSUYAKIN - JOURNAL OF THE JAPAN SOCIETY OF POWDER AND POWDER METALLURGY, vol. 59, no. 4, 1 April 2012 (2012-04-01), pages 180-184, XP055233280, JP ISSN: 0532-8799, DOI: 10.2497/jjspm.59.180
- C Nogi: "Rapid production of [beta]-FeSi 2 by spark-plasma sintering", Journal of materials science, 2 May 2000 (2000-05-02), pages 5845-5849, XP055264511, Retrieved from the Internet: URL:http://download.springer.com/static/pd f/334/art%3A10.1023%2FA%3A1026752206864.pd f?originUrl=http://link.springer.com/artic le/10.1023/A:1026752206864&token2=exp=1460 450445~acl=/static/pdf/334/art%253A10.1023 %252FA%253A1026752206864.pdf?originUrl=htt p%3A%2F%2Flink.springer.com%2Farticle%2F10 .1023%2FA% [retrieved on 2016-04-12]
- K B Kalmykov ET AL: "RANGE OF HOMOGENEITY OF THE b-Al 9 Mn 3 Si PHASE OF THE Al - Mn - Si SYSTEM AT 823 K Translated from Metallovedenie i Termicheskaya Obrabotka", metal science and heat treatment, 20 March 2011 (2011-03-20), pages 17-20, XP055264786, Retrieved from the Internet: URL:http://download.springer.com/static/pd f/568/art%3A10.1007%2Fs11041-011-9352-8.pd f?originUrl=http://link.springer.com/artic le/10.1007/s11041-011-9352-8&token2=exp=14 60472413~acl=/static/pdf/568/art%253A10.10 07%252Fs11041-011-9352-8.pdf?originUrl=htt p%3A%2F%2Flink.springer.com%2Farticle%2F10 .1007%2Fs1 [retrieved on 2016-04-12]
- TAKAHIRO YAMADA: 'Synthesis of Mn(AlxSil-x)2+o Solid Solutions Using NaAlSi and Their Thermoelectric Properties' JOURNAL OF THE JAPAN SOCIETY OF POWDER AND POWDER METALLURGY vol. 59, no. 4, April 2012, pages 180 - 184, XP055233280

## Description

### Technical Field

The present invention relates to a novel material having excellent oxidation resistance and n-type thermoelectric conversion characteristics even in the air.

### Background Art

In Japan, the yield of effective energy obtained from the primary energy supply is only about 30%, and about 70% of the energy is eventually discarded as heat into the atmosphere. In addition, the heat generated by combustion, for example, in factories, or garbage incineration plants is also released into the atmosphere without being converted to other energy. In this manner, we, humankind, waste a vast amount of heat energy and obtain only a small amount of energy from activities such as combustion of fossil energy.

To increase the yield of energy, it is effective to enable utilization of the heat energy released into the atmosphere. For that purpose, thermoelectric conversion in which heat energy is directly converted to electrical energy is an effective means. Thermoelectric conversion, which uses the Seebeck effect, is an energy conversion technique for generating electricity by creating a temperature difference between both ends of a thermoelectric conversion material to thereby produce a potential difference. In this technique, electricity can be obtained by simply placing one end of the thermoelectric conversion material at a portion heated to a high temperature by waste heat, placing the other end thereof in the air (room temperature), and connecting a conducting wire to both ends thereof. This technique does not require any mobile equipment such as a motor or a turbine, which is necessary for general electricity generation. Thus, the technique enables continuous generation of electricity without emitting combustion gas, or the like, at low cost until the thermoelectric conversion material is degraded.

As stated above, thermoelectric generation is expected to be a promising technology that plays a part in resolving energy problems, which are concerns for the future. However, to enable thermoelectric generation, there is a need for a thermoelectric conversion material with high thermoelectric conversion efficiency and high durability. In particular, it is important that such a thermoelectric conversion material is not oxidized in the air at the usage temperature.

CoO₂-based layered oxides such as Ca₃CO₄O₉ have been reported as materials exhibiting excellent thermoelectric performance in the air at a high temperature (see Non-patent Literature 1 below). However, while exhibiting high conversion efficiency at a temperature of about 600°C or more, these oxides exhibit low conversion efficiency in an intermediate temperature range of about 200°C to 600°C.

As a material exhibiting favorable thermoelectric conversion performance in the intermediate temperature range, MnSi_{1.7} has been known as a p-type thermoelectric conversion material to be relatively resistant to oxidation in the intermediate temperature range and to exhibit favorable thermoelectric characteristics (see Patent Literature 1 below).

Comparatively, as n-type thermoelectric conversion materials, although intermetallic compounds such as Mg₂Si, Skutterudite, and Half-Heusler exhibit favorable thermoelectric conversion performance in the intermediate temperature range, these intermetallic compounds are oxidized in air at a temperature of more than 300°C. Thus, these intermetallic compounds are unsatisfactory in durability and cannot be used for a long period of time.

### Citation List

### Patent Literature

PTL 1: JPS42-8128B

### Non-Patent Literature

NPL 1: R. Funahashi et al., Jpn. J. Appl. Phys., 39, L1127 (2000)
NPL 2: Kuz'ma Yu B. et al., "Untersuchungen im Dreistoff Mn-Al-Si", Monatsthefte fur Chemie,Vol. 94, 01/01/1964
NPL 3: Takashira Yamada et Al., "synthesis of Mn(AlxSi1-x)2+delta Solid solution using NaAlSi thermoelectric properties, Journal of the Japan Society of powder and powder metallurgy,Vol.59 (4),pages 180-184 (2012)

PT 2: JP2012124243

### Summary of Invention

### Technical Problem

The present invention has been accomplished in view of the aforementioned problems of the prior art techniques. A main object of the present invention is to provide a novel material usable as an n-type thermoelectric conversion material that exhibits satisfactory thermoelectric conversion performance in the intermediate temperature range and excellent durability in the air.

### Solution to Problem

The present inventors conducted extensive research to achieve the above object, and found that a crystalline metal material comprising Mn, Si and Al as essential components and at least one specific element at a specific ratio has a negative Seebeck coefficient and exhibits excellent electrical conductivity. The present inventors further found that the metal material exhibits excellent thermoelectric conversion performance in the air even in the intermediate temperature range of from room temperature to about 700°C and has satisfactory oxidation
resistance and excellent durability in this temperature range. The present inventors accordingly accomplished the present invention based on these findings.

More specifically, the present invention provides a metal material, and an n-type thermoelectric conversion material comprising the metal material as described below.
1. A metal material having a hexagonal closed-packed structure represented by compositional formula MnₓMySiₘAlₙ wherein M is at least one element selected from the group consisting of Ti,
   V, Cr, Fe, Co, Ni, and Cu; and 2.0<x<3.5, 0<y≤1 .4, 2.5<x+y<3.5, 3.5<m<4.5, and 1.5<n<2.49, the metal material having a negative Seebeck coefficient at a temperature of
   25°C or more, the metal material being in a crystalline form and wherein the element ratio of n/(x+y) is within the range of 0. 45 to 0.8
2. The metal material according to Item 1 having an electrical resistivity of 2 mΩ·cm or less at a temperature of 25°C or more.
3.An n-type thermoelectric conversion material comprising the metal material according to any one of Items 1 to 2 or a sintered body thereof.
4.A thermoelectric conversion module comprising the n-type thermoelectric conversion material according to Item 3.

The following describes the metal material according to the present invention in detail.

The metal material according to the present invention is represented as recited by the claim 1.

The metal material according to the present invention represented
by the above compositional formula is a crystalline material having a hexagonal close-packed structure.

The metal material represented by the above compositional formula has a negative Seebeck coefficient. When a temperature difference is created between one end and the other of a molded article formed of the metal material, the electric potential generated by the thermoelectromotive force becomes higher at the high-temperature side than at the low-temperature side. This shows the characteristics of the metal material as an n-type thermoelectric conversion material. More specifically, the metal material has a negative Seebeck coefficient at a temperature in the range of about 25 to 700°C.

The metal material has excellent electrical conductivity and low electrical resistivity; for example, the metal material exhibits a low electrical resistivity of 2 m^{q-} cm or less at a temperature in the range of 25 to 700°C. Furthermore, the metal material has excellent durability even under an oxidizing atmosphere such as in the air; for example, the metal material is almost free from deterioration in thermoelectric conversion performance even when used for a long period of time in the air at a temperature in the range of about 25 to 700°C. The probable reason for this is that an oxide film formed on the surface of the material inhibits the oxidation of the inner part of the material to thereby exhibit excellent oxidation resistance in the air.

In the metal material according to the present invention, the ratio of the atomic number of Al to the total atomic number of Mn and M in the
above-described compositional formula MnₓM_{y}SiₘAlₙ, the value of n/(x+y), is within the range of about 0.45 to 0.8. When the atomic number of Al falls within this range, the metal material can be used as an n-type thermoelectric conversion material exhibiting a particularly high figure of merit.

There is no particular limitation to the method for producing the metal material according to the present invention. For example, the metal material can be obtained by the following method.

First, raw materials are mixed in such a manner that the element ratio thereof becomes the same as that of the desired metal material, after which the raw material mixture is melted at a high temperature, and then cooled. Examples of usable raw materials include, in addition to elementary metals, intermetallic compounds comprising a plurality of constituent elements, solid solutions comprising a plurality of constituent elements, and composites thereof (such as alloys).

There is no particular limitation to the method for melting the raw materials; for example, a method such as arc melting or high frequency melting can be used. There is no particular limitation to the melting temperature, and it is sufficient as long as the heating temperature is raised until all of the raw materials are melted. Although the specific melting temperature depends on the type of raw materials used and the proportion of each material, it is typically sufficient as long as heating is performed until all of the raw materials are visually confirmed as melted at a temperature in the range of about 1,500 to 2,000°C. For example, when heated at a temperature of about 1,950°C, i.e., above the melting point of Cr, which has the highest melting point among those of the raw materials used, all of the raw materials typically exhibit a molten state.

There is also no particular limitation to the melting time. However, when the raw materials are maintained in a molten state for a long period of time, compositional change may occur because of the evaporation of elements used as raw materials. Thus, it is preferable to terminate the molten state in as short a period of time as possible after the raw materials are completely melted. For example, when the raw materials have a total weight of about 50 g or less, the time period for which the raw materials are maintained in a molten state is preferably about 10 to 200 seconds.

To prevent the oxidation of the raw materials, the melting is preferably performed under a non-oxidizing atmosphere, for example, under an inert gas atmosphere such as a helium or argon atmosphere; under a reduced-pressure atmosphere at about 50 kPa or less or a vacuum atmosphere; and under a reducing atmosphere such as a mixture gas atmosphere containing hydrogen at a partial pressure of 5% or less.

The melt of the metals obtained by the above method, after cooled, becomes a molten solid product represented by the desired compositional formula.

Even when the raw materials are melted in the above-stated non-oxidizing atmosphere, it is difficult to completely remove oxygen from the atmosphere, and residual oxygen is typically present. In addition, the raw materials tend to have oxides formed on the surface thereof. Therefore, when the raw materials are melted, the oxygen diffuses and reacts with Al, which is prone to oxidation, thus forming oxidized aluminium (alumina). Accordingly, the obtained metal material may contain Al at a compositional ratio smaller than the compositional ratio of Al charged as a raw material. However, this can be avoided by charging Al at a compositional ratio slightly larger than the desired compositional ratio of Al for the metal material to be obtained, or by using, as an Al material, an alloy that does not easily form oxides, such as an Si-Al alloy or an Mn-Al alloy.

The molten solidified product obtained by the above method, when optionally reheated and melted after pulverizing and mixing, becomes a solidified product that is more homogeneous in composition, crystal grain size and the like, thereby showing more enhanced performance as a thermoelectric conversion material. In this case, the conditions for the heat treatment are not particularly limited. Although the conditions depend on the types, amounts, etc., of the metallic elements contained, the heat treatment is preferably conducted at a temperature in the range of about 1,500 to 2,000°C. To prevent the oxidation of the raw materials, the heat treatment is preferably conducted under a non-oxidizing atmosphere as in the first melting step.

The molten solidified product obtained by the above method is already a metal material with a desired crystalline structure. However, for specific applications, for example, for use as a thermoelectric conversion material, the product is typically prepared in the form of a sintered body in a shape that is suitable for the intended use. To produce a sintered body, the molten solidified product represented by the compositional formula above is first pulverized into a fine powder, and then molded into a desirable shape. The degree of pulverization (particle size, particle size distribution, particle shape, etc.) is not particularly limited; however, making the powder as fine as possible facilitates the subsequent step (i.e., sintering). For example, the use of a pulverization means such as a ball mill enables simultaneous pulverizing and mixing of the molten solidified product. The method for sintering the pulverized product is not particularly limited, and any heating means, such as a commonly used electric heating furnace or gas heating furnace, may be employed. The heating temperature and heating time are also not particularly limited, and these conditions may suitably be determined so as to form a sintered body having sufficient strength. In particular, the use of electric current sintering enables the production of a precise sintered body in a short time. Electric current sintering is performed by placing a pulverized raw material in an electrically conductive mold, press-molding the material, and then sintering it under reduced pressure while applying a pulsed direct current to the mold. The conditions for electric current sintering are also not particularly limited; for example, electric current sintering may be performed by heating at a temperature of about 600 to 850°C for about 5 to 30 minutes optionally under an increased pressure of about 5 to 30 Mpa. To prevent the oxidation of the raw materials, the heating is preferably performed under a non-oxidizing atmosphere, for example, an inert gas atmosphere using nitrogen, argon, or the like; a reducing atmosphere; or a vacuum atmosphere.

The above method enables the production of a sintered body of a crystalline metal having a closed-packed hexagonal structure as written in claim 1.

The metal material according to the present invention obtained by the above method has a negative Seebeck coefficient at a temperature in the range of 25 to 700°C; and has a high negative Seebeck coefficient at a temperature of 600°C or less, in particular, in the range of about 300 to 500°C. The metal material exhibits a very low electrical resistivity of 2 mQ-cm or less at a temperature in the range of 25 to 700°C. Accordingly, the metal material can exhibit excellent thermoelectric
conversion performance as an n-type thermoelectric conversion material in the above temperature ranges. Furthermore, the metal material has excellent heat resistance, oxidation resistance, etc. For example, the metal material is almost free from deterioration in thermoelectric conversion performance, even when used for a long period of time at a temperature in the range of about 25 to 700°C.

Taking advantage of the above characteristics enables the effective use of the metal material according to the present invention, for example, as an n-type thermoelectric conversion material usable in the air at a temperature in the range of room temperature to about 600°C, and preferably about 300 to 500°C.

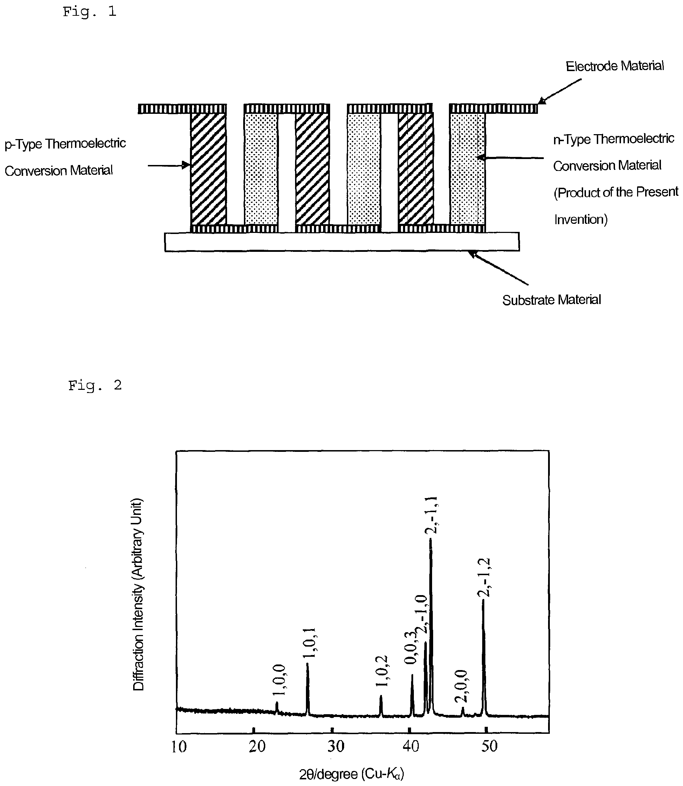

Fig. 1 schematically shows one example of a thermoelectric generation module that comprises a thermoelectric conversion material formed of a sintered body of the metal material according to the present invention as an n-type thermoelectric conversion element. The thermoelectric generation module has a structure similar to that of known thermoelectric generation modules. The thermoelectric generation module comprises a substrate material, a p-type thermoelectric conversion material, an n-type thermoelectric conversion material, electrodes, etc., wherein the metal material of the present invention is used as an n-type thermoelectric conversion material.

### Advantageous Effects of Invention

The metal material according to the present invention has a negative Seebeck coefficient and low electrical resistivity, and further exhibits excellent heat resistance, oxidation resistance, and the like.

Taking advantage of such characteristics enables the effective use of the metal material as an n-type thermoelectric conversion material that exhibits excellent performance at a temperature in the range of room temperature to about 600°C even in the air under which conventional materials are difficult to use for a long period of time. Accordingly, when a sintered body formed of the metal material is incorporated into a system as an n-type thermoelectric conversion element for a thermoelectric generation module, thermal energy, which used to be released into the atmosphere, can be effectively used.

### Brief Description of Drawings

Fig. 1 is a schematic diagram illustrating a thermoelectric generation module including a sintered body formed of a metal material according to the present invention as an n-type thermoelectric conversion material.
Fig. 2 shows a powder X-ray diffraction pattern of the sintered body formed of the metal material obtained in Example 1. The pattern was determined at room temperature.
Fig. 3 is a graph showing the temperature dependence of the Seebeck coefficient of each of the sintered bodies formed of the metal materials obtained in Examples 1 to 3. The dependence was measured in the air at 25 to 700°C.
Fig. 4 is a graph showing the temperature dependence of the electrical resistivity of the sintered bodies formed of the metal materials obtained in Examples 1 to 3. The dependence was measured in the air at 25 to 700°C.
Fig. 5 is a graph showing the temperature dependence of the thermal conductivity of the sintered body formed of the metal material obtained in Example 1. The dependence was measured in the air at 25 to 700°C.
Fig. 6 is a graph showing the temperature dependence of the dimensionless thermoelectric figure of merit (ZT) of the sintered body formed of the metal material obtained in Example 1. The dependence was measured in the air at 25 to 700°C. Fig. 7 is a graph showing the change in electrical resistivity of the metal material obtained in Example lover time. The change was observed under conditions that the metal material was maintained in the air at 600°C.

### Description of Embodiments

The following Examples will describe the present invention in more detail.

### Example 1 (not part of the invention)

The following raw materials, manganese (Mn) as a source of Mn, silicon (Si) as a source of Si, and aluminum (Al) as a source of Al, were mixed such that Mn:Si:Al (elemental ratio) was 3.0:4.0:2.3. The raw material mixture was melted by using an arc-melting method in an argon atmosphere under reduced pressure at about 35 kPa; the melt was then fully mixed, and cooled to room temperature to obtain a molten solidified product comprising the above metal components.

Subsequently, the obtained alloy was pulverized using an agate mortar and a pestle. The obtained powder was then pressed into a disc shape having a diameter of about 40 mm and a thickness of about 3 mm. The result was placed in a carbon mold, heated to 750°C by applying a pulsed direct current of about 2,700 A (pulse width: 2.5 milliseconds, frequency: 29 Hz), and maintained at that temperature for 15 minutes. After performing electric current sintering, the application of current and pressure was stopped, and the result was allowed to cool to obtain a sintered body.

The obtained sintered body was pulverized into a powder, and measured with X-ray diffraction at room temperature by using copper as an X-ray source target. Fig. 2 shows the obtained X-ray diffraction pattern. The Miller indice assigned to each diffraction peak revealed that the sintered body obtained in Example 1 is in the form of crystals having a hexagonal close-packed lattice.

### Examples 2 to 35 (example 36 is not part of the invention)

The sintered bodies of the compositions shown in Tables 1 and 2 were obtained in the same manner as in Example 1 except that the types and proportions of the raw materials were altered. As the raw materials, the elementary metal of each material was used.

The sintered bodies obtained in Examples 2 to 36 were analyzed with X-ray diffraction in the same manner as in Example 1. The results showed that all of the sintered bodies were in the form of crystals having a hexagonal close-packed lattice.

### Test Example

The Seebeck coefficient, electrical resistivity, thermal conductivity, and dimensionless figure of merit of each sintered body obtained in Examples 1 to 36 were determined by using the methods described below.

The following describes the method for determining the physical-property values to evaluate the thermoelectrical characteristics. The Seebeck coefficient and electrical resistivity were measured in air, and the thermal conductivity was measured in a vacuum.

### Seebeck Coefficient

A sample was molded in a rectangular shape so as to have a cross-section of about 3 to 5 mm square and a length of about 3 to 8 mm. An R-type thermocouple (platinum-platinum-rhodium) was attached to each end of the sample using a silver paste. The sample was placed in a tubular electric furnace, heated to 100 to 700°C, and given a temperature difference by applying room-temperature air to one of the ends to which the thermocouples are attached by using an air pump. Thereafter, the thermoelectromotive force generated between both ends of the sample was measured using a platinum wire of the thermocouples. The Seebeck coefficient was calculated on the basis of the thermoelectromotive force and the temperature difference between the ends of the sample.

### Electrical Resistivity

A sample was molded in a rectangular shape so as to have a cross-section of about 3 to 5 mm square and a length of about 3 to 8 mm. Using a silver paste and a platinum wire, electric current terminals were provided at both ends, and voltage terminals were provided at the side surfaces. The electrical resistivity was measured by a DC four-terminal method.

To assess the stability in the air, the electrical resistivity of the sample was measured in the air for two consecutive days under condition that the sample was placed in a furnace at 600°C.

### Thermal Conductivity

A sample was molded into a shape so as to have a width of about 5 mm, a length of about 8 mm, and a thickness of about 1.5 mm. The thermal diffusivity and specific heat were measured by a laser flash method. The thermal conductivity was calculated by multiplying the resulting values by the density determined by using the Archimedes' method.

Tables 1 and 2 below show the Seebeck coefficient (pV/K), electrical resistivity (mΩ·cm), thermal conductivity (W/m·K²), and dimensionless figure of merit at 300°C of each alloy obtained in the Examples.
*- the examples are not part of the invention

**Table 1**

| No. | Composition | Seebeck Coefficient at 300°C (µV/K) | Electrical Resistivity at 300°C (mΩ·cm) | Thermal Conductivit y at 300°C (W/m·K²) | Dimensionle ss Figure of Merit at 300°C *ZT* |
|---|---|---|---|---|---|
| 1 | Mn₃Si₄Al_{2.3} * | -91.7 | 0.87 | 4.4 | 0.13 |
| 2 | Mn_{2.9}Cr_{0.1}Si₄Al₂ | -131 | 1.11 | 4.3 | 0.20 |
| 3 | Mn_{2.7}Cr_{0.3}Si₄Al₂ | -156 | 1.06 | 4.6 | 0.29 |
| 4 | Mn_{2.6}Cr_{0.4}Si₄Al₂ | -148 | 1.19 | 4.6 | 0.24 |
| 5 | Mn_{2.6}Cr_{0.4}Si_{3.5}Al₂ | -66.6 | 1.41 | 4.4 | 0.04 |
| 6 | Mn_{2.6}Cr_{0.4}Si_{4.5}Al_{1.5} | -40.3 | 1.12 | 3.6 | 0.02 |
| 7 | Mn_{2.6}Cr_{0.4}Si_{3.5}Al_{2.4} | -113 | 1.25 | 4.4 | 0.14 |
| 8 | Mn_{2.3}Cr_{0.7}Si₄Al₂ | -7.13 | 0.89 | 3.5 | 0.001 |
| 10 | Mn_{2.7}Ti_{0.3}Si₄Al₂ | -73.1 | 0.78 | 4.6 | 0.09 |
| 11 | Mn_{2.7}V_{0.3}Si₄Al₂ | -47.4 | 0.98 | 4.5 | 0.30 |
| 12 | Mn_{2.7}Fe_{0.3}Si₄Al₂ | -39.9 | 0.65 | 3.9 | 0.04 |
| 13 | Mn_{2.7}Co_{0.3}Si₄Al₂ | -43.5 | 0.70 | 4.3 | 0.04 |
| 14 | Mn_{2.7}Ni_{0.3}Si₄Al₂ | -59.9 | 1.00 | 4.4 | 0.05 |
| 15 | Mn_{2.7}Cu_{0.3}Si₄Al₂ | -35.6 | 0.57 | 3.9 | 0.03 |
| 16 | Mn_{2.3}Ti_{0.7}Si₄Al₂ | -3.59 | 0.37 | 4.5 | 0.0004 |
| 17 | Mn_{2.3}V_{0.7}Si₄Al₂ | -8.70 | 0.39 | 4.8 | 0.002 |
| 18 | Mn_{2.3}Fe_{0.7}Si₄Al₂ | -18.5 | 0.67 | 4.7 | 0.006 |

**Table 2**

| No. | Composition | Seebeck Coefficien t at 300°C (µV/K) | Electrical Resistivit y at 300°C (mΩ·cm) | Thermal Conductivi ty at 300°C (W/m·K²) | Dimensionl ess Figure of Merit at 300°C *ZT* |
|---|---|---|---|---|---|
| 19 | Mn_{2.3}Co_{0.7}Si₄Al₂ | -11.5 | 0.75 | 4.5 | 0.002 |
| 20 | Mn_{2.3}Ni_{0.7}Si₄Al₂ | -17.5 | 0.34 | 4.7 | 0.01 |
| 21 | Mn_{2.3}Cu_{0.7}Si₄Al₂ | -6.51 | 0.23 | 4.7 | 0.002 |
| 22 | Mn_{2.0}Cr_{0.3}Ti_{0.2}Si₄Al₂ | -127 | 0.89 | 4.3 | 0.24 |
| 23 | Mn_{2.0}Cr_{0.3}V_{0.2}Si₄Al₂ | -108 | 0.91 | 4.3 | 0.17 |
| 24 | Mn_{2.0}Cr_{0.3}Fe_{0.2}Si₄Al₂ | -133 | 0.92 | 4.1 | 0.27 |
| 25 | Mn_{2.0}Cr_{0.3}CO_{0.2}Si₄Al₂ | -121 | 1.01 | 4.2 | 0.20 |
| 26 | Mn_{2.0}Cr_{0.3}Ni_{0.2}Si₄Al₂ | -119 | 0.89 | 4.5 | 0.20 |
| 27 | Mn_{2.0}Cr_{0.3}Cu_{0.2}Si₄Al₂ | -78.7 | 0.78 | 4.5 | 0.10 |
| 28 | Mn_{2.5}Cr_{0.3}Ti_{0.5}Si₄Al₂ | -70.2 | 0.81 | 4.5 | 0.08 |
| 29 | Mn_{2.0}Cr_{0.7}Ti_{0.7}Si₄Al₂ | -22.3 | 0.62 | 4.8 | 0.01 |
| 30 | Mn_{2.0}Cr_{0.7}V_{0.7}Si₄Al₂ | -31.9 | 0.56 | 4.7 | 0.02 |
| 31 | Mn_{2.0}Cr_{0.7}Cr_{0.7}Si₄Al₂ | -27.8 | 0.53 | 4.8 | 0.02 |
| 32 | Mn_{2.0}Cr_{0.7}Fe_{0.7}Si₄Al₂ | -33.2 | 0.61 | 4.6 | 0.02 |
| 33 | Mn_{2.0}Cr_{0.7}Co_{0.7}Si₄Al₂ | -18.6 | 0.58 | 4.8 | 0.007 |
| 34 | Mn_{2.0}Cr_{0.7}Ni_{0.7}Si₄Al₂ | -21.4 | 0.49 | 4.9 | 0.01 |
| 35 | Mn_{2.0}Cr_{0.7}Cu_{0.7}Si₄Al₂ | -8.01 | 0.20 | 4.9 | 0.004 |
| 36 | Mn_{3.5}Si₄Al_{2.49} * | -118 | 1.09 | 4.7 | 0.16 |

As is evident from the above results, all of the sintered bodies formed of the metal materials obtained in Examples 1 to 36 had a negative Seebeck coefficient and low electrical resistivity at 300°C, thus exhibiting excellent performance as an n-type thermoelectric conversion material.

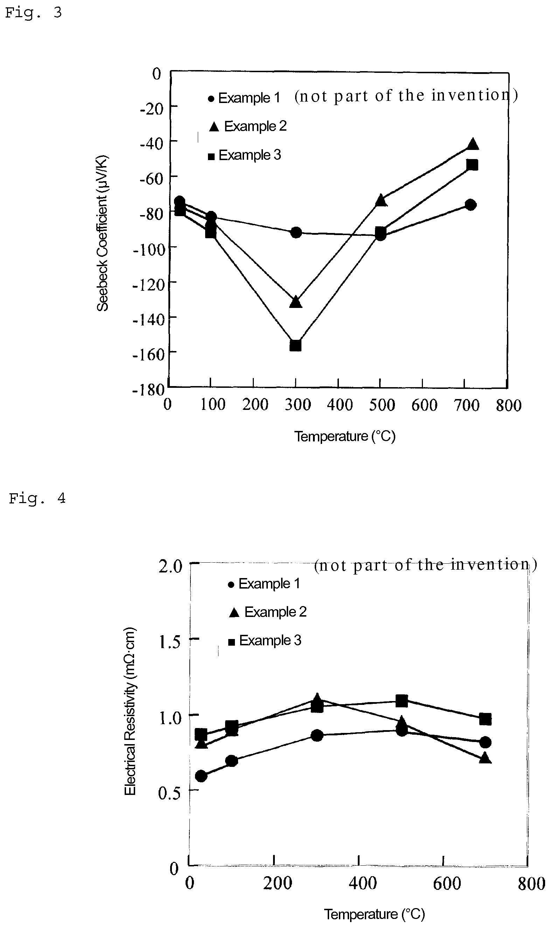

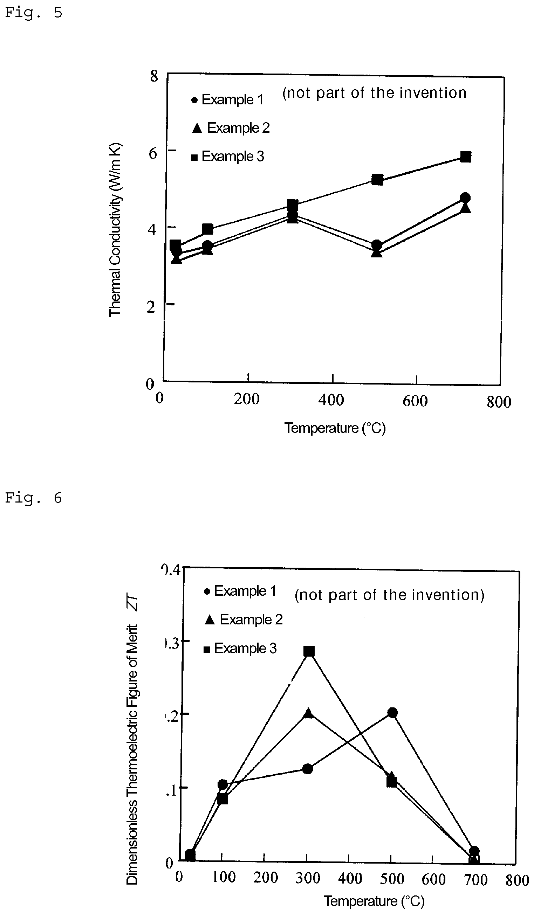

Fig. 3 is a graph showing the temperature dependence of the Seebeck coefficient of each of the sintered bodies formed of the metal materials obtained in Examples 1 to 3 measured in the air at 25 to 700°C. Fig. 4 is a graph showing the temperature dependence of the electrical resistivity measured in the air at 25 to 700°C. Fig. 5 is a graph showing the temperature dependence of the thermal conductivity measured in the air at 25 to 700°C. Fig. 6 is a graph showing the temperature dependence of the dimensionless figure of merit (ZT) measured in the air at 25 to 700°C.

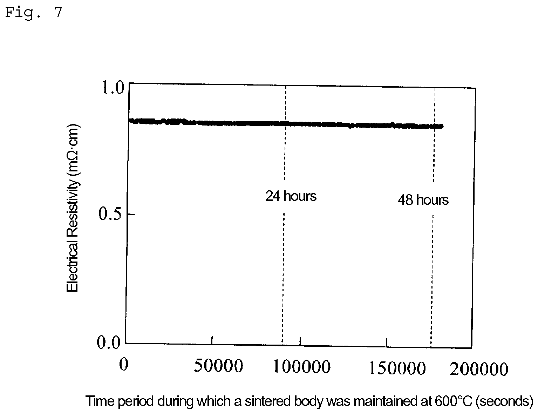

Fig. 7 is a graph showing the change in electrical resistivity over time, which was observed under condition that the sintered body formed of the metal material obtained in Example 1 was maintained in the air at 600°C for two consecutive days.

As is evident from the above results, the sintered bodies formed of the metal materials obtained in Examples 1 to 3 had a negative Seebeck coefficient at a temperature in the range of 25 to 700°C. Thus, the sintered bodies were confirmed to be n-type thermoelectric conversion materials, in the high-temperature side of which a high electric potential is established. These sintered bodies had a high absolute value of the Seebeck coefficient at a temperature in the range of 600°C or less, in particular about 300 to 500°C.

Further, the sintered bodies formed of the metal materials obtained in Examples 1 to 3 had an electrical resistivity (ρ) below 2 mΩ·cm at a temperature in the range of 25 to 700°C, thus exhibiting excellent electrical conductivity. As seen from Fig. 7, which shows the results of continuous measurement of electrical resistivity in the air at 600°C, performance deterioration caused by oxidation was not observed. Therefore, the metal material according to the present invention is excellent in oxidation resistance.

Accordingly, the sintered bodies formed of the metal materials obtained in the above Examples can be effectively used as an n-type thermoelectric conversion material in the air at a temperature of up to about 600°C, particularly within the range of about 300 to 500°C.

## Claims

1. A metal material having a hexagonal close-packed structure represented by compositional formula MnₓM_{y}SiₘAlₙ wherein M is at least one element selected from the group consisting of Ti, V, Cr, Fe, Co, Ni, and Cu; and 2.0≤x≤3.5, 0≤y≤1.4, 2.5≤x+y≤3.5, 3.5≤m≤4.5, and 1.5≤n≤2.49, the metal material having a negative Seebeck coefficient at a temperature of 25°C or more, the metal material being in a crystalline form and wherein the elemental ratio of n/(x+y) is within the range of 0.45 to 0.8.

2. The metal material according to Claim 1 having an electrical resistivity of 2 mΩ·cm or less at a temperature of 25°C or more.

3. An n-type thermoelectric conversion material comprising the metal material according to any one of Claims 1 to 2 or a sintered body thereof.

4. A thermoelectric conversion module comprising the n-type thermoelectric conversion material according to Claim 3.

## Patentansprüche

1. Metallmaterial mit einer hexagonalen dicht gepackten Struktur, dargestellt durch die Zusammensetzungsformel MnₓM_{y}SiₘAlₙ, worin M mindestens ein Element ausgewählt aus der Gruppe bestehend aus Ti, V, Cr, Fe, Co, Ni und Cu ist; und 2,0 ≤ x ≤ 3,5, 0 < y ≤ 1,4, 2,5 ≤ x + y ≤ 3,5, 3,5 ≤ m ≤ 4,5 und 1,5 ≤ n ≤ 2,49, wobei das Metallmaterial einen negativen Seebeck-Koeffizienten bei einer Temperatur von 25 °C oder mehr aufweist, das Metallmaterial in einer kristallinen Form ist und wobei das Elementverhältnis n/(x + y) im Bereich von 0,45 bis 0,8 liegt.

2. Metallmaterial nach Anspruch 1 mit einem spezifischen elektrischen Widerstand von 2 mΩ·cm oder weniger bei einer Temperatur von 25 °C oder mehr.

3. Thermoelektrisches Umwandlungsmaterial vom n-Typ, umfassend das Metallmaterial nach irgendeinem der Ansprüche 1 bis 2 oder einen Sinterkörper davon.

4. Thermoelektrisches Umwandlungsmodul, umfassend das thermoelektrische Umwandlungsmaterial vom n-Typ nach Anspruch 3.

## Revendications

1. Matériau de métal ayant une structure à assemblage compact hexagonal représenté par la formule de composition MnₓM_{y}SiₘAlₙ dans laquelle M est au moins un élément choisi dans le groupe constitué de Ti, V, Cr, Fe, Co, Ni et Cu ; et 2,0 ≤ x ≤3, 5, 0 < y ≤ 1,4, 2, 5 ≤x + y ≤ 3,5, 3,5 ≤ m ≤4,5 et 1,5 ≤ n ≤ 2,49, le matériau de métal ayant un coefficient de Seebeck négatif à une température de 25 °C ou plus, le matériau de métal étant sous forme cristalline et dans lequel le rapport élémentaire de n/(x + y) est dans la plage de 0,45 à 0,8.

2. Matériau de métal selon la revendication 1, ayant une résistivité électrique de 2 mΩ·cm ou moins à une température de 25 °C ou plus.

3. Matériau de conversion thermoélectrique de type n comprenant le matériau de métal selon l'une quelconque des revendications 1 et 2 ou un corps fritté de celui-ci.

4. Module de conversion thermoélectrique comprenant le matériau de conversion thermoélectrique de type n selon la revendication 3.
